# EUROPEAN PATENT APPLICATION

(11) **EP 4 117 046 A1**
(43) Date of publication of application: **11.01.2023**
(21) Application number: 20923393.1
(22) Date of filing: 03.03.2020
(51) Int. Cl.: H01L 33/00

(54) **METHOD FOR MANUFACTURING LIGHT EMITTING UNIT**

(71) Applicant: Fuji Corporation, Chiryu-shi, Aichi 472-8686 (JP)
(72) Inventor: TANIZAWA, Yoshiharu, Chiryu-shi, Aichi 472-8686 (JP)
(74) Representative: Grünecker Patent- und Rechtsanwälte PartG mbB
(86) International application number: PCT/JP2020/008893
(87) International publication number: WO 2021/176554

(57) **Abstract**

In a method for manufacturing a light emitting unit, multiple LED elements are mounted on the same unit board to manufacture a light emitting unit. In this method, multiple combinations of brightness and color of LED elements configured to be mounted on the same unit board are created as management data, and multiple LED elements of which brightness and color match any combination of the multiple combinations included in the management data are mounted on the same unit board.

## Description

### Technical Field

The present specification discloses a method for manufacturing a light emitting unit.

### Background Art

Conventionally, there has been known a method for manufacturing a light source unit by selecting the required number of LEDs from multiple LEDs supplied and mounting the selected required number of LEDs on a board. For example, when manufacturing a light source unit in which the required number of LEDs are arranged in a band-shaped bar, Patent Literature 1 discloses that each of the multiple supplied LEDs is finely ranked into multiple chromaticity populations within the chromaticity range, each of these LEDs is finely ranked into multiple luminous flux populations according to the numerical value of the luminous flux, further ranked according to the numerical value of the forward voltage, and then the LEDs belonging to each rank are appropriately combined to designate an arrangement position of a light source unit on the bar.

### Patent Literature

Patent Literature 1: JP-A-2011-254064

### Summary of the Invention

### Technical Problem

Incidentally, when manufacturing a light emitting unit in which multiple LED elements are mounted on a unit board, it is preferable to select an LED element having as uniform brightness and color as possible in order to reduce variation in brightness and color between the LED elements. However, when the brightness and color of the LED elements that can be mounted on the same unit board are strictly controlled, the more the characteristics to be managed, the fewer the LED elements that can be used and the more the in-process products.

An object of the present disclosure is to provide a method for manufacturing a light emitting unit capable of suppressing variation in a light emitting state between multiple LED elements mounted on the same unit board, and increasing the number of LED elements as mounting targets to suppress generation of in-process products, as compared with a method for strictly managing brightness and color of the LED elements.

### Solution to Problem

The present disclosure adopts the following means in order to achieve the main object described above.

It is a gist that a method for manufacturing a light emitting unit of the present disclosure is a method for manufacturing a light emitting unit by mounting multiple LED elements on the same unit board, the method including creating multiple combinations of brightness and color of LED elements configured to be mounted on the same unit board as management data, and manufacturing the light emitting unit by mounting multiple LED elements of which brightness and color match any combination of the multiple combinations included in the management data on the same unit board.

In the method for manufacturing a light emitting unit of the present disclosure, multiple combinations of brightness and color of LED elements configured to be mounted on the same unit board are created as management data, and multiple LED elements of which brightness and color match any combination of the multiple combinations included in the management data are mounted on the same unit board. As a result, it is possible to suppress variation in the light emitting state between multiple LED elements mounted on the same unit board, and increase the number of LED elements as mounting targets to suppress the generation of in-process products, as compared with a method for strictly managing the brightness and color of the LED elements.

### Brief Description of Drawings

[Fig. 1] Fig. 1 is a schematic configuration diagram of a multi-chamfered board;
[Fig. 2] Fig. 2 is a schematic configuration diagram of a component mounter;
[Fig. 3] Fig. 3 is an explanatory diagram illustrating an example of a manufacturing step of a light emitting unit;
[Fig. 4] Fig. 4 is an explanatory diagram illustrating an example of management data;
[Fig. 5] Fig. 5 is an explanatory diagram illustrating an example of a characteristic class of an LED; and
[Fig. 6] Fig. 6 is an explanatory diagram illustrating an example of LEDs to be mounted on each unit board of the multi-chamfered board.

### Description of Embodiments

Next, an embodiment of the present disclosure will be described with reference to the drawings.

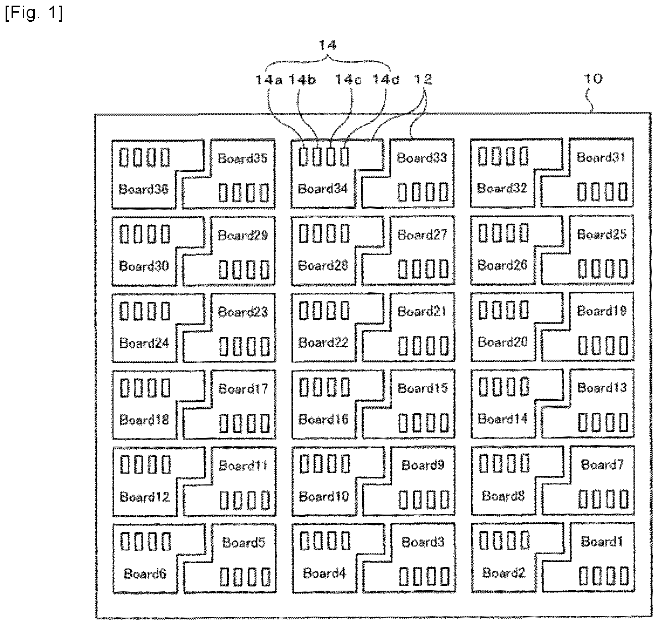

Fig. 1 is a schematic configuration diagram of a multi-chamfered board. As illustrated in the drawing, multi-chamfered board 10 is an aggregate board including multiple unit boards 12 (slave boards). In the present embodiment, multiple pairs of unit boards 12 having the same shape (substantially L-shaped) reversed by 180 degrees are arranged vertically and horizontally on multi-chamfered board 10. Each unit board 12 is separated from each other by dividing grooves. Multi-chamfered board 10 can easily separate each unit board 12 along the dividing groove by pressing each unit board 12. In Fig. 1, each unit board 12 is also referred to as a board, and a number described at the end thereof represents an identification number.

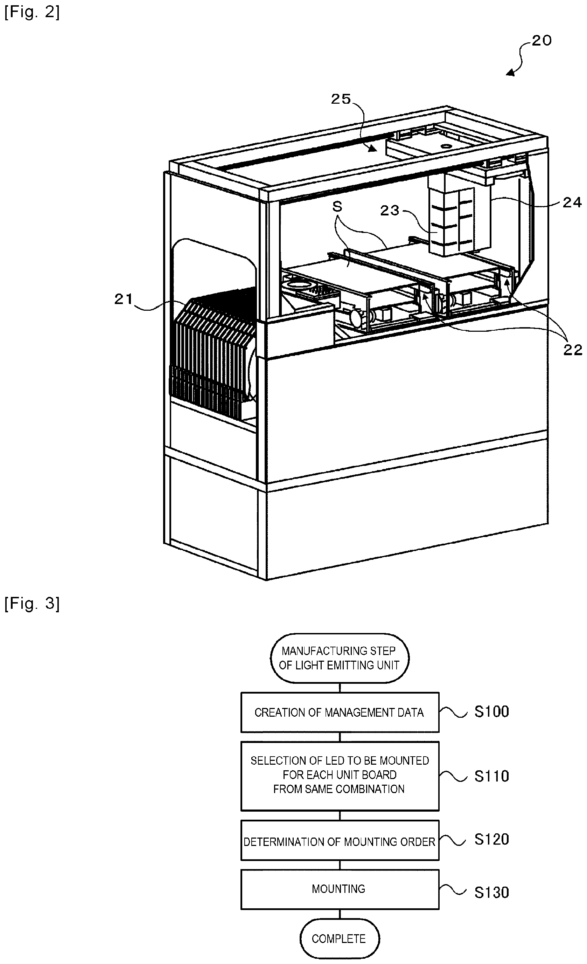

Multiple LEDs 14 (14a to 14d) are mounted on each unit board 12 (four in the illustrated example). In the present embodiment, unit board 12 on which multiple LEDs 14 are mounted constitutes one light emitting unit. The mounting of LEDs 14 on unit board 12 is performed by component mounter 20. Fig. 2 is a schematic configuration diagram of component mounter 20. As illustrated in the drawing, component mounter 20 includes feeder 21 (for example, tape feeder or tray feeder) for supplying LED 14 as an electronic component, board conveyance device 22 for conveying multi-chamfered board 10 as board S, mounting head 23 having a nozzle for picking up LED 14 supplied from feeder 21, and head moving device 24 for moving mounting head 23. Component mounter 20 sequentially mounts LEDs 14 from feeder 21 by mounting head 23 according to a predetermined mounting order on each unit board 12 included in multi-chamfered board 10.

Here, LEDs 14 have variations in brightness, color, and the like due to individual differences in manufacturing. Therefore, when the light emitting unit is manufactured by mounting multiple LEDs 14 on unit board 12, each LED 14 to be mounted on the same unit board 12 is selected so that the brightness and color of each LED 14 in unit board 12 are as uniform as possible. However, when the brightness and color of each LED 14 to be mounted on the same unit board 12 are strictly managed, the number of LEDs 14 as mounting targets decreases, and the number of in-process products increases. Therefore, in the manufacturing method for the light emitting unit of the present embodiment, multiple combinations of the brightness, color, and forward voltage (voltage) of LEDs 14 that can be mounted on the same unit board 12 are registered as management data, so that LEDs 14 in which brightness, color, and voltage match any of the registered combinations can be mounted on the same unit board 12 as a mounting target.

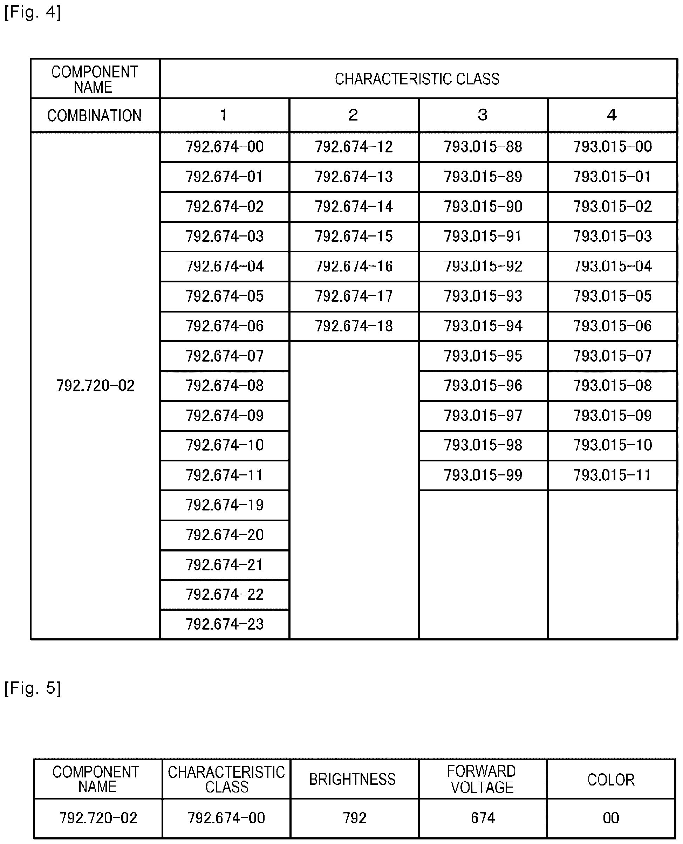

Fig. 3 is an explanatory diagram illustrating an example of a manufacturing step of the light emitting unit. In the manufacturing step of the light emitting unit, first, management data for managing LEDs 14 that can be mounted on the same unit board 12 is created (S 100). Fig. 4 is an explanatory diagram illustrating an example of management data. Fig. 5 illustrates an example of a characteristic class of an LED. In Fig. 5, in the characteristic class [792.674-00], [792] represents brightness, [674] represents voltage, and [00] represents color. As illustrated in Fig. 4, the management data includes a component name and a characteristic class of LED 14. Here, the characteristic class is a group of combinations of the brightness, color, and forward voltage of LEDs 14 that can be mounted on the same unit board 12 for each combination. LEDs 14 included in the same combination can be regarded as having a uniform light emitting state between LEDs 14, and can be mounted on the same unit board 12. The number of combinations is not limited to multiple combinations, and may be only one.

Subsequently, for each unit board 12 included in multi-chamfered board 10, multiple LEDs 14 to be mounted on the same unit board 12 are selected from the same combination of management data (S110). As illustrated in Fig. 4, for example, in a case where multiple LEDs 14 to be mounted on the same unit board 12 are selected from combination 1, multiple LEDs 14 are selected from a combination having a brightness of 792, a voltage of 674, and colors of 00 to 11 and 19 to 23. In addition, in a case where multiple LEDs 14 to be mounted on the same unit board 12 are selected from combination 2, multiple LEDs 14 are selected from a combination having a brightness of 792, a voltage of 674, and colors of 12 to 18. Furthermore, in a case where multiple LEDs 14 to be mounted on the same unit board 12 are selected from combination 3, multiple LEDs 14 are selected from a combination having a brightness of 793, a voltage of 015, and colors of 00 to 11.

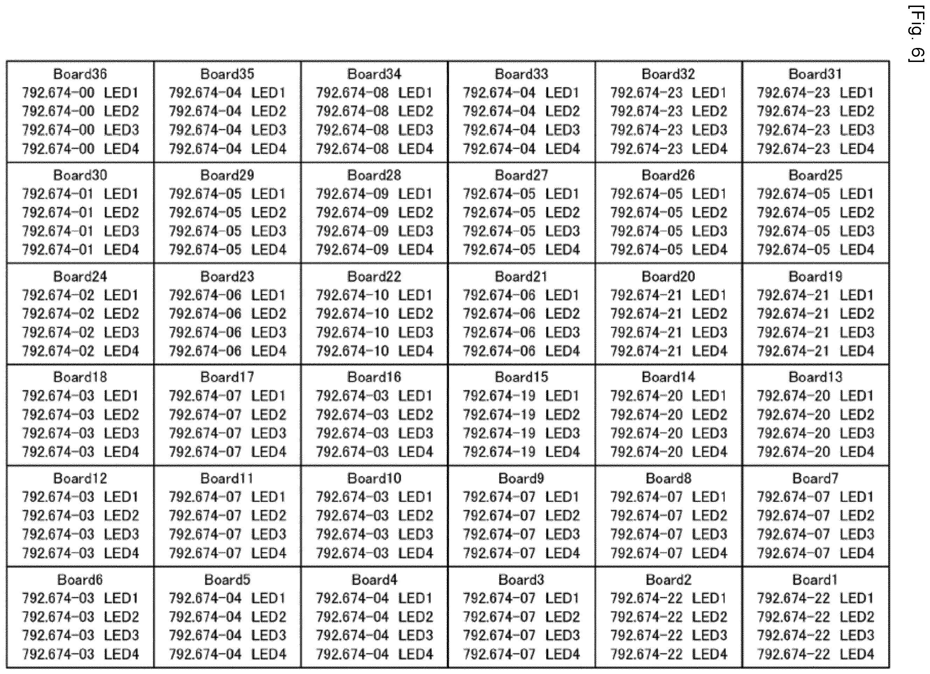

Next, a mounting order of LEDs 14 to be mounted on each unit board 12 included in multi-chamfered board 10 is determined (S120). In component mounter 20, LEDs 14 are mounted on each unit board 12 in the determined mounting order (S130), and the steps are completed. Fig. 6 is an explanatory diagram illustrating an example of LEDs to be mounted on each unit board of the multi-chamfered board. As illustrated in the figure, LEDs 14 selected from the same combination are mounted on multi-chamfered board 10 for each unit board 12 (board). As a result, the light emitting state (brightness, color, and forward voltage) of each LED 14 in unit board 12 can be made as uniform as possible. In addition, by giving a range to the characteristic classes (brightness, voltage, and color) of LEDs 14 that can be mounted on the same unit board 12 according to the management data (can be regarded as the same light emitting state), the number of LEDs 14 that can be the mounting targets can be increased to suppress the generation of in-process products.

Here, a correspondence relationship between main elements of the embodiment and main elements of the present disclosure described in the aspects will be described. That is, LED 14 of the present embodiment corresponds to the LED element of the present disclosure, and unit board 12 (slave board) corresponds to the unit board. In addition, multi-chamfered board 10 corresponds to an aggregate board.

It goes without saying that the present disclosure is not limited to the above-described embodiment, and may be performed in various aspects without departing from the technical scope of the present disclosure.

For example, in the manufacturing method for the light emitting unit of the above embodiment, the brightness, color, and forward voltage of LED 14 are included in the management data, and the forward voltage may not be included in the management data. Even in this case, the brightness and color of multiple LEDs 14 mounted on the same unit board 12 can be made uniform.

In the manufacturing method for the light emitting unit of the above embodiment, in multi-chamfered board 10 having multiple unit boards 12, the combination of the brightness and color of LED 14 that can be mounted on the same unit board 12 for each unit board 12 (slave board) is managed as management data. However, the manufacturing method for the light emitting unit is not limited to multi-chamfered board 10, and in a board having only one unit board, a combination of brightness and color of LED that can be mounted on the unit board may be managed as management data.

As described above, it is a gist that a method for manufacturing a light emitting unit of the present disclosure is a method for manufacturing a light emitting unit by mounting multiple LED elements on the same unit board, the method including creating multiple combinations of brightness and color of LED elements configured to be mounted on the same unit board as management data, and manufacturing the light emitting unit by mounting multiple LED elements of which brightness and color match any combination of the multiple combinations included in the management data on the same unit board.

In the method for manufacturing a light emitting unit of the present disclosure, multiple combinations of brightness and color of LED elements configured to be mounted on the same unit board are created as management data, and multiple LED elements of which brightness and color match any combination of the multiple combinations included in the management data are mounted on the same unit board. As a result, it is possible to suppress variation in the light emitting state between multiple LED elements mounted on the same unit board, and increase the number of LED elements as mounting targets to suppress the generation of in-process products, as compared with a method for strictly managing the brightness and color of the LED elements.

In such a method for manufacturing a light emitting unit of the present disclosure, multiple combinations of brightness, color, and forward voltage of the LED elements configured to be mounted on the same unit board may be created as management data, and the light emitting unit may be manufactured by mounting multiple LED elements of which brightness, color, and forward voltage match any combination of the multiple combinations included in the management data on the same unit board. Accordingly, it is possible to further suppress variation in the light emitting state between multiple LED elements mounted on the same unit board. In addition, by having multiple combinations of brightness, color, and forward voltage configured to be mounted on the same unit board, the number of LED elements as the mounting targets can be increased to suppress the generation of in-process products.

In addition, in the method for manufacturing a light emitting unit according to the present disclosure, the unit board may be a slave board obtained by dividing an aggregate board, and the management data may be managed for each slave board. Accordingly, by selecting the LED elements to be mounted on each slave board, it is possible to suppress variation in the light emitting state of each product.

Furthermore, in the method for manufacturing a light emitting unit according to the present disclosure, the management data may have multiple sets of the multiple combinations, and the light emitting unit may be manufactured by mounting multiple LED elements of which brightness and color match any combination of the multiple combinations included in the management data in the same set on the same unit board.

### Industrial Applicability

The present disclosure can be applied to a manufacturing industry of a light emitting unit or the like.

### Reference Signs List

10 multi-chamfered board, 12 unit board, 14, 14a to 14d LED, 20 component mounter, 21 feeder, 22 board conveyance device, 23 mounting head, 24 head moving device, 25 slider, S board

## Claims

1. A method for manufacturing a light emitting unit for manufacturing the light emitting unit by mounting multiple LED elements on the same unit board, the method comprising:
creating multiple combinations of brightness and color of LED elements configured to be mounted on the same unit board as management data; and
manufacturing the light emitting unit by mounting multiple LED elements of which brightness and color match any combination of the multiple combinations included in the management data on the same unit board.

2. The method for manufacturing a light emitting unit according to claim 1, further comprising:
creating multiple combinations of brightness, color, and forward voltage of the LED elements configured to be mounted on the same unit board as management data, and
manufacturing the light emitting unit by mounting multiple LED elements of which brightness, color, and forward voltage match any combination of the multiple combinations included in the management data on the same unit board.

3. The method for manufacturing a light emitting unit according to claim 1 or 2, wherein
the unit board is a slave board obtained by dividing an aggregate board, and
the management data is managed for each slave board.

4. The method for manufacturing a light emitting unit according to any one of claims 1 to 3, wherein
the management data has multiple sets of the multiple combinations, and
the light emitting unit is manufactured by mounting multiple LED elements of which brightness and color match any combination of the multiple combinations included in the management data in the same set on the same unit board.
